# EUROPEAN PATENT SPECIFICATION

(11) **EP 0 972 612 B1**
(45) Date of publication and mention of the grant of the patent: **18.02.2004**
(21) Application number: 99305476.6
(22) Date of filing: 09.07.1999
(51) Int. Cl.: B24B 37/04, B24D 13/14

(54) **Polishing pad**
Polierkissen
Tampon de polissage

(30) Priority: 15.07.1998 JP 20001398
(43) Date of publication of application: 19.01.2000
(73) Proprietor: NIPPON PILLAR PACKING CO. LTD., Osaka-shi Osaka-fu (JP)
(72) Inventor: Otawa, Kazuhiko, c/o Nippon Pillar Packing Co.,Ltd, Yodogawa-ku (JP); Fukumoto, Toshiyuki, Nippon Pillar Packing Co.,Ltd, Yodogawa-ku (JP); Kawakami, Yasuaki, c/o Nippon Pillar Pack. Co.,Ltd, Sanda-shi, Hyogo-ken (JP)
(74) Representative: Crump, Julian Richard John

(56) References cited:
- EP-A- 0 607 441
- WO-A-98/14304
- US-A- 5 584 146
- US-A- 5 609 517

## Description

The present invention relates to polishing pads, and has particular reference to polishing pads for polishing materials such, for example, as semiconductor silicon wafers to a high level of smoothness.

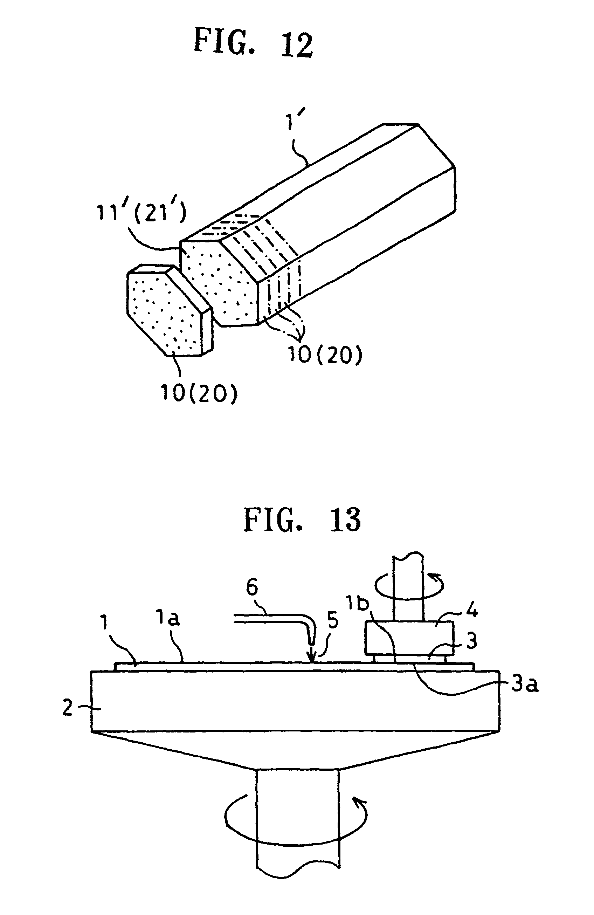

With the miniaturization of integrated circuits (LSI), has come the need to polish the surfaces of semiconductor silicon wafers to a high degree of smoothness. Such polishing is usually carried out by chemical mechanical polishing (CMP) using a surface polishing apparatus of the kind shown in Fig. 13, for example. The surface polishing apparatus of Fig. 13 has a rotary table 2 with a polishing pad 1 spread and fixed thereupon, a top ring 4 installed over the rotary table 2 and movable in the vertical direction to hold a work piece 3 to be polished, such as a semiconductor silicon wafer, and a polishing solution nozzle 6 adapted to supply onto the polishing pad 1 a polishing solution (slurry) 5 with abrasive grains such as SiO₂ and Al₂O₃ suspended therein. In operation, the rotary table 2 and the top ring 4 rotate independently of each other, with the polishing solution 5 being supplied onto the polishing pad 1 from the polishing solution nozzle 6 and with the top ring 4 pressing the surface to be polished (the lower surface 3a of the work piece 3) against the upper surface (the polishing surface 1a) of the polishing pad 1. In this way, the work piece surface 3a is polished to a high degree of smoothness (specular surface), with the polishing solution 5 placed between the work piece surface 3a to be polished and the polishing pad surface 1a.

Among known examples of suitable polishing pads 1 are those formed of nonwoven fabrics with randomly arranged polyester fibres partially impregnated and hardened with polyurethane resin, and those made of foam structured sheet of the urethane type such as foam structured (porous) polyurethane sheet. Such kinds of pad 1, porous in structure with many fine pores scattered in the polishing pad surface 1a, exhibit excellent polishing characteristics. Said pores are responsible for increased retention of the polishing solution 5 on the polishing pad surface 1a. The pores also work to keep the work piece 3 from sticking to the polishing pad surface 1a.

The problem with such prior art porous structured polishing pads 1 is that the pores formed in the surface layer of the pad 1, including the polishing pad surface 1a, are varied in size and irregular in position and arrangement (pore arrangement pattern i.e. positional relation between the pores). This contributes to lowered polishing rate, increased non-uniformity in polished amount in the same work piece surface to be polished (the surface of wafer), faulty polishing or damaged surface and the like. Because of such non-uniformed irregular or scattered polishing performances, it is difficult to obtain a good polished surface.

To further illustrate, the area 1b of the polishing pad surface 1a with which the work piece surface 3a to be polished comes in contact (work piece contact area 1b) moves as the rotary table 2 and the top ring 4 rotate. If the polishing pad surface is irregular in pore size and pore-arrangement pattern, then the work piece contact area 1b of the polishing pad surface 1a will change in pore formation (number of the pore, size, pattern, etc.) as it moves. Furthermore, the pore formation of the polishing pad surface 1a changes every moment in accordance with decrease in thickness of the pad as the polishing goes on. For example, as the polishing pad surface wears with the progress of the polishing process, some shallow pores will disappear while other pores under the surface will come out. In this way, the polishing pad surface 1a changes in pore number, size and pattern. It is also feared that a polishing pad surface studded with shallow pores (including pores shallowed by wearing of the pad surface) could cause faulty polishing (resulting in a damaged polished surface) because abrasive grains and/or polishing dust, retained and accumulated in the shallow pores, could shave the polishing work piece surface 3a locally deep. Thus, the prior art polishing pads formed of nonwoven fabrics, urethane-type foam-structured sheet etc. have presented the problem that they would change with progress of polishing process in polishing characteristics of the pad-work piece contact area 1b such as retention of polishing solution, polishing rate and non-uniformity.

WO 98/14304 discloses a polishing pad with tubular or solid bar like polishing elements, respectively, which are embedded in a carrier matrix that separates one element from the adjacent one. The matrix material and therefore the space between the polishing elements is impermeable for the polishing fluid.

It is an object of the invention to provide a novel polishing pad. In particular it is an object of the present invention to provide a polishing pad which can polish the surface of work pieces such, for example, as semiconductor silicon wafers with satisfactory results without such problems as are encountered with the prior art.

According to the present invention therefore there is provided a polishing pad as claimed in claim 1 or claim 2 below.

The polishing pad of the present invention thus comprises an assemblage of elongate resin polishing elements, which elements are tubular or solid having a minute diameter, and are inseparably bound together, outer peripheral surface to outer peripheral surface, such that the axial direction end faces of said elements are aligned on a plane at one end of said elements, so as to form a plate structure with pores regularly positioned and arranged and passing therethrough in the axial direction. In some embodiments, the axial end faces at both ends of the elements may be aligned on a respective plane. As used herein, the term "axial direction" means the longitudinal direction of the polishing elements and is a concept identical with the thickness direction of the polishing pad. The expression "outer peripheral surface" as used herein denotes the outer surface portion of the polishing element except for the axial direction end faces.

Said elements may comprise solid bar-like, columnar elements, which elements are assembled in such a way as to form gaps extending in the axial direction (thickness direction of the polishing pad) between the outer peripheral surfaces of the elements. If the elements are solid, columnar in shape, for example, they are brought together, with outer peripheral surfaces in linear contact with each other in which the contact line extends in the axial direction. The elements are linked to each other with the contact areas alone bonded together to produce gaps between the outer peripheral surfaces, which gaps are isolated from each other by the linked lines (linear contact portions). Said gaps serve as polishing pad pores.

In some embodiments, said elements may comprise hollow elements that are open at least at one end. Preferably said elements are tubular. The elements may be bound together either in such a way as to form gaps as described above, or not to form such gaps between the outer peripheral surfaces. In the former case, the pores in that pad are the bores of the respective elements and, in addition, the gaps formed between the elements. In the latter case, the pores are the centre bores only.

The outer peripheral surfaces may be bound together by thermal fusion or with an adhesive. The polishing pad of the present invention can also be bonded to a base as necessary. Said base may be of fabrics such, for example, as nonwoven fabrics, etc. That is, the polishing pad comprises a plurality of layers with the respective layers placed one on another in the thickness direction, wherein the surface layer is formed of the plate structure which comprises a large number of tubular or columnar resin polishing elements bound together to form one piece.

Following is a description by way of example only with reference to the accompanying drawings of embodiments of the present invention.

In the drawings:-
Fig. 1 is a top view of a polishing pad according to a first embodiment of the present invention.
Fig. 2 is an enlarged view of the core part of Fig. 1.
Fig. 3 is a vertical, sectional view of the core part taken on line III - III in Fig. 1.
Fig. 4 is a vertical, sectional view of the core part taken on line IV - IV in Fig. 1.
Fig. 5 is a top view of a polishing pad according to a second embodiment of the present invention.
Fig. 6 is an enlarged view of the core part of Fig. 5.
Fig. 7 is a vertical, sectional view of the core part taken on line III - III in Fig. 5.
Fig. 8 is a vertical, sectional view of the core part taken on line IV - IV in Fig. 5.
Fig. 9 is a top view of a variation of the polishing pad.
Fig. 10 is a top view of another variation of the polishing pad.
Fig. 11 is a top view of yet another variation of the polishing pad.
Fig. 12 is a perspective illustration of a polishing pad or a plate structure being cut.
Fig. 13 is a side view of a typical surface polishing apparatus in which the polishing pad may be mounted.

### Example 1

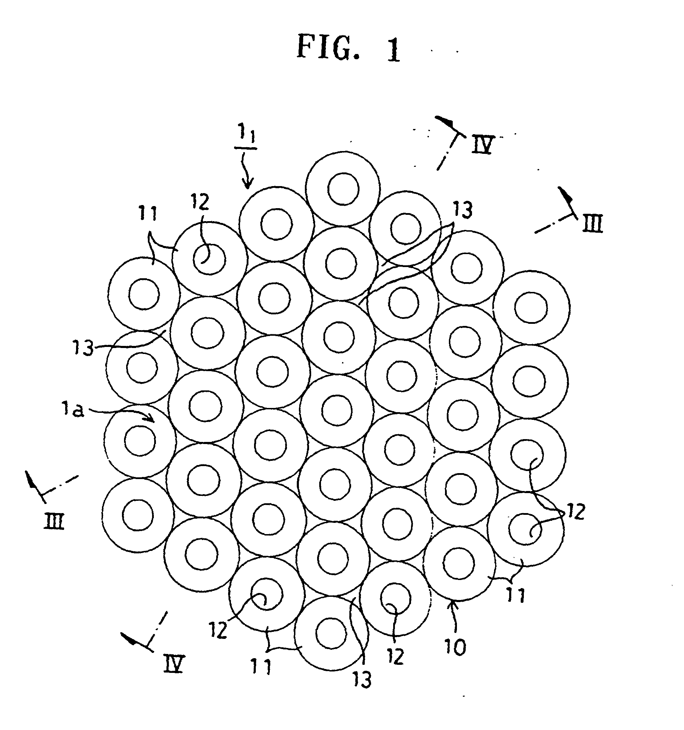

Figs. 1 to 4 show a first polishing pad 1, for chemical mechanical polishing (CMP) in accordance with a first embodiment of the present invention. This is an example of the application of the present invention to a polishing pad which can be spread and fixed on a rotary table 2 (either bonded directly to the rotary table 2 or to the top of a surface plate mounted on the table 2) of a surface polishing apparatus such, for example, as the apparatus as shown in Fig. 13.

Said first polishing pad l₁ is formed of a large number of resin polishing elements 11, all tubular with a minute diameter, inseparably bound together, outer peripheral surface to outer peripheral surface, with the axial direction tube end faces aligned on a plane, to form a plate structure 10 with pores 12, 13 regularly positioned and arranged and passing through the plate in the thickness direction or the axial direction of the elements. This plate structure 10 can be bonded onto the rotary table 2 or on the top of a surface plate mounted on the table 2 of the surface polishing apparatus. With such an arrangement, a work piece 3 to be polished such for example as semiconductor silicon wafer can be polished on the surface with satisfactory results.

The polishing elements 11 are cylindrical ultra-fine tubes or hollow fibres with an identical diameter and length in the axial direction. Said polishing elements 11 are made of such materials as fluororesin or a polymer plastic (e.g. polypropylene, polyethylene, polyacetal, urethane-type plastics). The choice of material is made according to the polishing conditions, such as the properties of the work piece 3 and the polishing solution 5, the hardness required of the polishing pad surface, and the like. If the polishing solution is corrosive as acid, for example, then a corrosion-resistant material such as fluororesin is used. The length of the polishing element 11 is set depending on the required thickness of the pad I₁ but generally the length is about 1 to 15 mm.

The polishing elements 11 are bonded together into one piece, with the axial direction tube end faces aligned on a plane, and with each polishing element 11 brought in linear contact with six surrounding polishing elements 11 in a zigzag or staggered pattern as shown in Figs. 1. The polishing elements 11 are bonded to each other at linear contact areas alone by thermal fusion or with an adhesive to form a plate structure 10. The plate structure 10 thus has gaps 13 isolated from each other by the bonded areas 14 and formed between the outer peripheral surfaces, with the surface of the plate structure 10 formed with the axial direction tube end faces.

The first pad l₁ comprising such a plate structure 10 has a polishing pad surface 1a formed with the axial tube end faces of the polishing elements 11 where a pore-arrangement pattern with two kinds of pores 12, 13 pass through the plate structure 10 in the axial direction, and are positioned and arranged regularly over the surface. The first pores 12 are pores in the centres of the tubular polishing elements 11, while the second pores 13 are gaps formed between the outer peripheral surfaces and separated from each other by bonded areas 14. Those pores too are positioned in a regular pattern. It is also noted that the first pores 12 all have the same cross sectional shape and extend from one end face to the other in the thickness direction or the axial direction. So do the second pores 13. In other words, the pore formation (number, size, arrangement etc. of first pores 12 and second pores 13) is identical as seen at any cross section including the polishing pad surface 1a.

The inside diameter (pore size) and the wall thickness of the polishing element 11 determine the holding capacity of the pad for the polishing solution 5 (capacity of the first pore 12), the polishing performance of the polishing pad surface 1a, etc., and are set properly according to the polishing conditions. For the following reasons, the inside diameter is preferably 0.02 to 3 mm, and the wall thickness 0.5 to 2 mm.

If the inside diameter of the polishing element 11 is less than 0.02 mm, the contact area between the polishing element 11 and the work piece 3 to be polished may be larger than necessary, thus failing to maintain the required polishing solution holding capacity. As a result, the contact area between the polishing element 11 and the work piece 3 may turn into the state of boundary lubrication, making it difficult to polish the work piece surface 3a to a desired surface roughness. If, on the other hand, the inside diameter of the polishing element 11 exceeds 3 mm, the holding capacity of the pad provided by the first pores 12 may be larger than necessary, which may render the contact area between the polishing element 11 and the work piece 3 into a state of fluid film lubrication. In such a state of fluid film lubrication, the polishing pad, topped with a thin coat of the polishing solution, could cut out minute protrusions on the work piece surface 3a, but could not remove satisfactorily large protrusions such as undulations on the work piece surface 3a, thus failing to polish the work piece surface 3a to a desired flatness.

Similarly, the second pores 13, which hold the polishing solution along with the first pores 12, are set in the same sectional area size range as the first pore 12 in the polishing element 11, i.e the sectional area equivalent to that of the first pore 12 with an inside diameter of 0.02 to 3 mm.

If the wall thickness of each polishing element 11 is less than 0.5 mm, furthermore, the local pressing force applied on the work piece surface 3a may become higher than necessary, making it difficult to polish the work piece surface 3a uniformly. With a polishing element wall thickness of more than 2 mm, on the other hand, the overall rigidity of the pad may rise more than necessary, which may hinder smooth polishing of the work piece surface 3a. With such a polishing pad 1, the work piece surface 3 a may be impossible to finish to a high degree of smoothness.

The number of polishing elements 11 forming the plate structure 10 is set at 200 to 1,000,000 depending on such factors as the element diameter and size of the first pad l₁. The shape of the plate structure 10 can be chosen depending on the type of the rotary table 2 or the surface plate on which the first pad l₁ is spread and fixed, but is generally hexagonal or circular. In the present example, a hexagonal shape is adopted as shown in Fig. 1.

The first pad l₁ thus formed is uniform in pore formation in the polishing pad surface 1a of the pad l₁ and in any cross-sectional face thereunder and is regular in pore-arrangement pattern. With the pad l₁, therefore, it is possible to carry out polishing with satisfactory results, without such problems as drops in polishing rate, an non-uniform polished amount in the work piece surface (wafer) or damaged polished surfaces. There will be substantially no change in the pore formation (pore number, size, pattern, etc.) even when the work piece contact area 1b on the polishing pad surface 1a, that is the area on the polishing pad surface 1a with which the polishing work piece surface 3a comes in contact, moves as the rotary table 2 and the top ring 4 rotate, because the pores 12, 13 in the polishing pad surface 1 a are uniform and are regularly arranged and positioned. Being identical at any cross-sectional face including the polishing pad surface 1a, furthermore, the pore formation will stay uniform and unchanged as the pad wears and decreases in thickness as a result of conditioning or polishing. The polishing pad of the present invention is less likely to damage the work piece surface 3a and can produce a uniformly polished surface as compared with prior art pads having shallow pores, because the pores 12, 13 in the pad of the present invention are through pores formed through the plate 10 in the pad thickness direction.

It is necessary to ensure that the polishing pad surface 1a should have physical and chemical properties in accordance with the polishing conditions, such as the properties of the work piece 3, polishing solution 5, and the like. Such requirements can easily be met by choosing a suitable material for the polishing element 11. The polishing pad surface 1a does not change in physical and chemical properties as the pad surface wears out.

Thus, the polishing pad surface 1a and the work piece contact area 1b on the polishing pad surface 1a undergo substantially no changes in the capacity of holding the polishing solution, polishing rate and uniformity, etc. with the progress of the polishing process. That is, there will occur substantially no nonuniformity in polishing performance. In addition, since the polishing characteristics can be maintained at a fixed level, it is possible to properly control the polishing process on the basis of such limited factors as polishing time. This way, it is possible to provide an optimum polishing meeting the requirements imposed on the work piece 3.

### Example 2

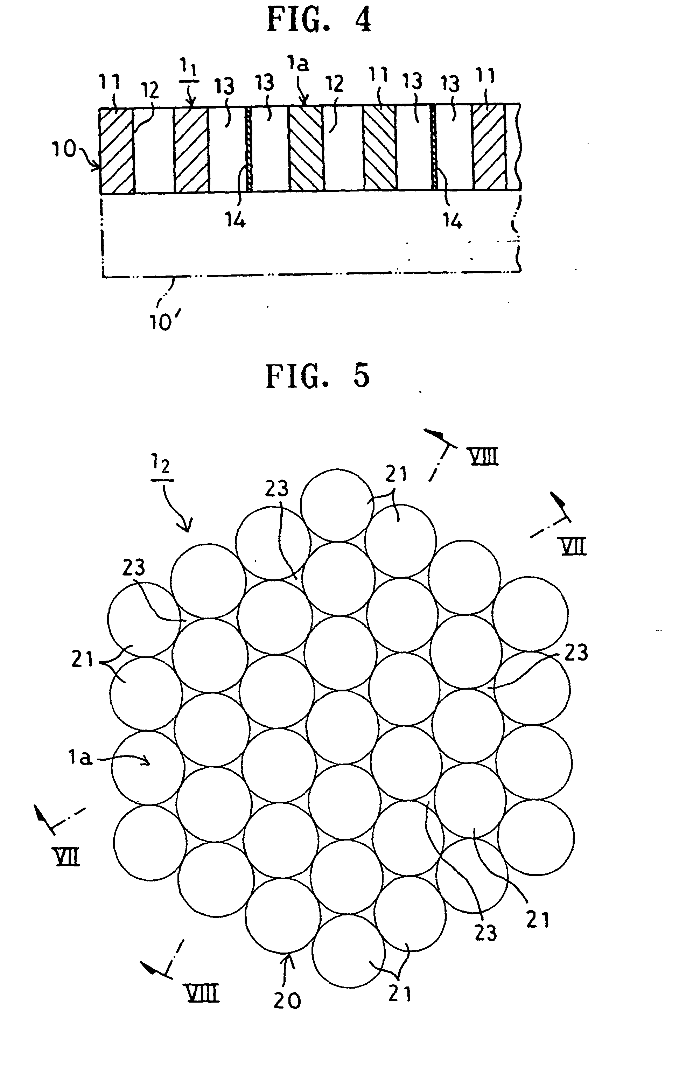

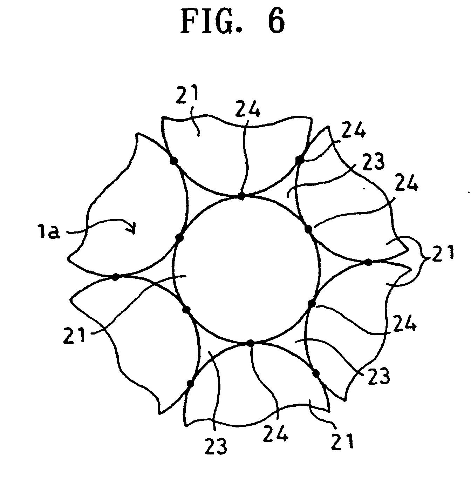

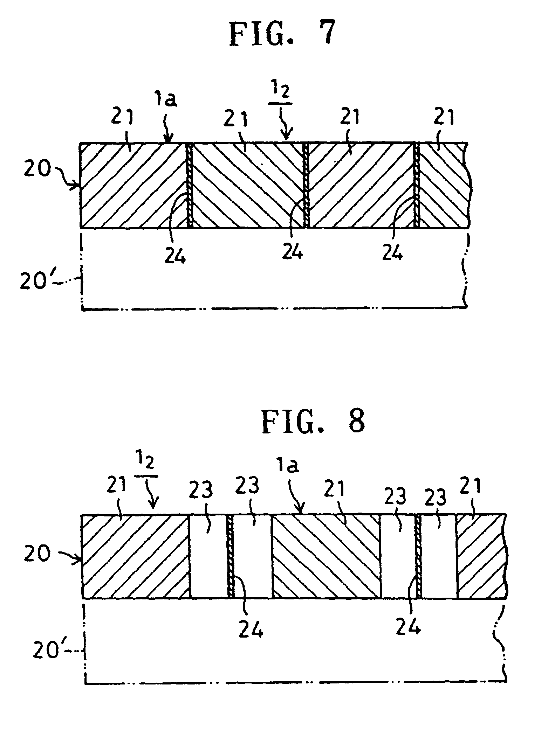

Figs. 5 to 8 show a second embodiment of the present invention. In this example, as in the first embodiment, the present invention is applied to a polishing pad 1 which can be spread and fixed on a rotary table 2 (either directly bonded on the rotary table 2 or on the top of a surface plate mounted on the table 2) of a surface polishing apparatus such as the apparatus shown in Fig. 13.

The second polishing pad l₂ of the second embodiment of the present invention comprises a large number of resin polishing elements 20, all solid bar-like, columnar in shape with a minute diameter, inseparably bound together, outer peripheral surface to outer peripheral surface, with the axial direction bar end faces aligned on a plane, to form a plate structure 20 in such a way that gaps are formed between the outer peripheral surfaces, which gaps constitute pores 23 extending in the axial direction as shown in Figs. 5 to 8. Said pores 23 are regularly positioned and arranged. This plate structure 20 can be bonded onto the rotary table 2 or onto the top of a surface plate mounted on the table 2 of the surface polishing apparatus. With such an arrangement, a work piece 3 such, for example, as a semiconductor silicon wafer can be polished on the surface with satisfactory results.

The polishing elements 21 are solid bar-like, columnar fibres or linear bodies, all with the same diameter and the same length in the axial direction. Such polishing elements 21 are made of such materials as fluororesin or a polymer plastic (like polypropylene, polyethylene, polyacetal, urethane-type plastics). Said materials may be selected according to the polishing conditions, such as the properties of the work piece 3 and the polishing solution 5. The outside diameter of each polishing element 21 is set properly according to the polishing conditions. Generally, the outside diameter is preferably 0.5 to 3 mm for the same reason that the wall thickness of the tubular polishing element 11 of Example 1 is set at 0.5 to 2 mm. The length of the polishing element 21 is generally set at preferably 1 to 5 mm depending on the such factors as the thickness of the second pad 12. as in the case of the aforesaid polishing element 11.

The polishing elements 21 are bonded into one piece, with the axial direction end faces of the elements 21 aligned on a plane and with each polishing element 21 brought into linear contact, outer peripheral surface to outer peripheral surface, with six surrounding polishing elements 21, thereby forming a zigzag, staggered pattern as shown in Figs. 5 to 8. That is, the polishing elements 21 are bonded to each other at linear contact areas alone by thermal fusion or with an adhesive into a plate structure 20. The plate structure 20 has gaps 23 which are formed between the outer peripheral surfaces and isolated from each other by the bonded areas 24, with the frontal surface of the structure 24 formed with the axial end faces of the elements 21.

The second pad l₂ comprising such a plate structure 20, has a polishing pad surface 1a formed of the axial end faces of the polishing elements 21, with a pore arrangement pattern in which pores 23 of one kind pass through in the axial direction and are arranged regularly over the surface. Said pores 23 are gaps formed between the outer peripheral surfaces of the elements and are partitioned from each other by bonded linear areas. Said pores are positioned and arranged in the polishing pad surface 1a in a regular pattern. It is also noted that the pores 23 each have the same cross-section and extend from one end face to the other in the thickness direction or the axial direction. In other words, the pore formation (number, size, arrangement, etc.) of said pores 23 is identical at any cross-section including the polishing pad surface 1a. In this connection, it is preferred that the size of the pores 23 should be equivalent to that of the pores 12, 13 in the first polishing pad l₁ of Example 1, for the same reason as that for which the inside diameter of the aforesaid polishing element 11 has been set.

The number of polishing elements 21 forming the plate structure 20 is set at about 200 to 1,000,000 depending on such factors as the element diameter and size of the second pad l₂. The shape of the plate structure 20 can be chosen depending on the form of the rotary table 2 or the surface plate on which the second pad l₂ is intended to be spread and fixed, but is generally hexagonal or circular. In the present example, a hexagonal shape is adopted as shown in Fig. 5.

Like the first pad l₁, the second pad l₂ thus formed is substantially uniform in pore formation in the surface layer including the polishing pad surface 1a of the pad l₂ and is regular in pore-arrangement pattern. With this pad l₂, therefore, it is possible carry out polishing with satisfactory results, without such problems as lowered polishing rates, non-uniform polished amount in the work piece surface (wafer) or damaged polished surfaces.

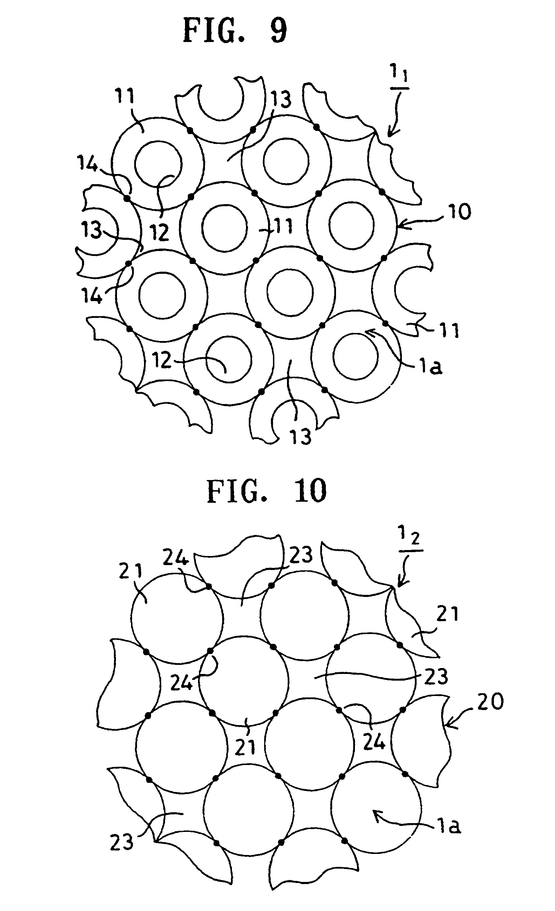

The polishing elements 11;21 making up the first pad l₁ or the second pad l₂ may be bonded, outer peripheral surface to outer peripheral surface, in any way. The polishing elements 11;21 may be bound into one piece, each polishing element 11;21 in linear contact with four surrounding polishing elements 11;21 in a chequered pattern as shown in Figs. 9 and 10, for example. The polishing element 11; 21 may have any cross-sectional shape, and is specifically not limited to a tubular shape or a columnar shape that is circular in cross-section; except that columnar polishing elements 21 with specific cross-sectional shapes that can be bound together into one piece only in such a way that no through gaps are formed in the axial direction between the outer peripheral surfaces are excluded. An example of such an excluded configuration is a plate structure 20 formed by putting together hexagonal columnar, solid bar-like polishing elements 21 in a honeycomb pattern, which do not form through-pores 23 in the axial direction. On the other hand, if hexagonal tubular polishing elements 11 are bound together into a plate structure 10 in a honeycomb pattern with no gaps formed between the outer peripheral surfaces, for example, the centre pores in the elements 11 are left open to form first pores 12.

The bonding strength with which the outer peripheral surfaces are linked is enough if the bonding is just so strong that the polishing elements 11;21 will not detach from one another during polishing. For example, it is acceptable if the linear contact areas 14; 24 are bonded in part instead of being bonded over the entire line from one end face to the other by thermal fusion. Also, plate structures 10;20 may be formed with a plurality of different kinds of polishing elements with different cross sections or end faces, as long as one or more kinds of pores 12,13;23 are formed in those polishing elements and are arranged regularly. In such case; polishing elements of different materials may be used as necessary.

In the preceding examples, the first pad l₁ or the second pad l₂ are formed by binding and bonding together a large number of polishing elements 11;21 into a plate structure 10;20. A plurality of such plate structures 10;20 may be arranged on the same plane side by side and bonded to form the pad. Fig. 10 shows such an example in which a plurality of plate structures 10;20, each formed by binding polishing elements 11;21 into a hexagon, are bonded into one piece in a honeycomb pattern by thermal fusion. This way, it is possible to reduce the number of constituent elements for each plate structure 10;20 (down to a range of 10 to 10,000). This method is simpler than forming one pad l₁ ;l₂ with one plate structure 10;20. A large polishing pad is easier to make that way. In this case, plate structures 10;20 of different materials and constructions (pore formation, etc.) also may be bonded together into one piece as necessary.

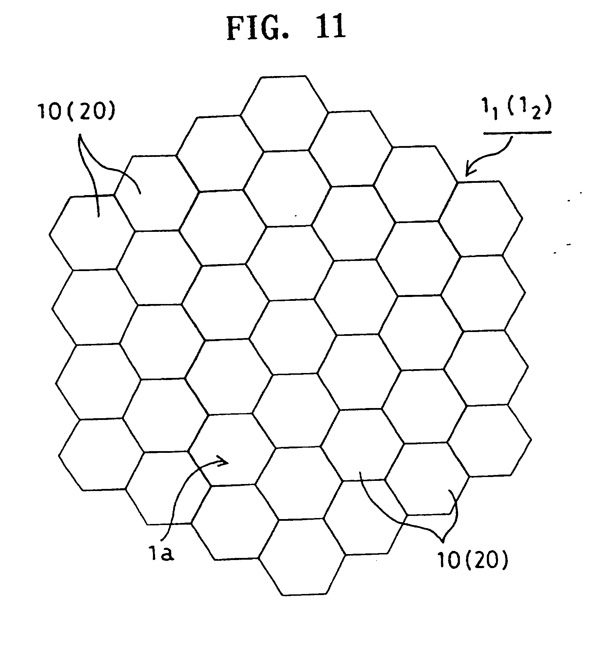

In the preceding examples, the plate structures 10;20 are formed by bonding together polishing elements, whose length is equivalent to the thickness thereof. The plate structures 10;20 also may be made another way: As shown in Fig. 11, polishing elements 11' (of a large length, which are the same as the polishing elements 11 in shape except for length) or 21' (of a large length, which are the same as the polishing element 21 in shape except for length) are bound together into a one piece or a bar-shaped, columnar structure 1' in the same way as in making the plate structures 10;20. The bar-shaped structure 1' thus formed, a hexagonal structure, for example, may be cut to a desired thickness to obtain a plurality of plate structures 10;20. In this method, it is possible to make efficiently polishing pads 1 and plate structures 10;20 in large numbers. This method is very convenient in making a polishing pad of such a construction as shown in Fig. 10.

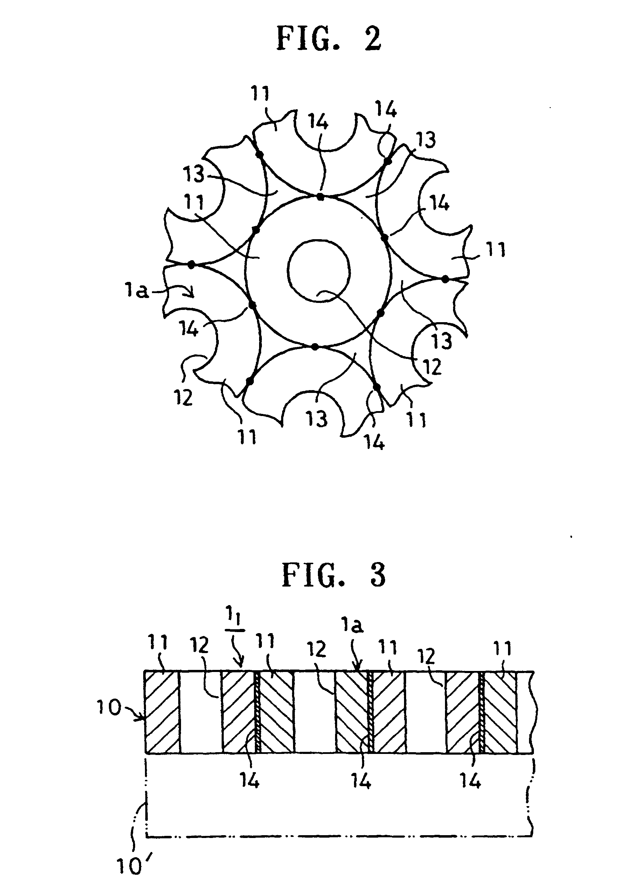

It is also noted that while in the preceding examples, plate structures 10;20 are used in a one-layer structure form, the polishing pad may be formed of a plurality of layers placed one upon another, with the surface layer formed of the plate structures 10;20. For example, the first pad l₁ or the second pad l₂ may be built up, with base 10';20' made of nonwoven fabrics or the like topped with plate structures 10;20 formed by bonding a plurality of plate structures as shown in Fig. 10 as indicated by chained lines in Figs. 3 and 4 or Figs. 7 and 8.

As set forth above, the polishing pad of the present invention is identical in pore formation at any cross-section, including the pad surface, with the pores positioned and arranged in a regular pattern, and therefore can polish the work piece surface as by CMP without presenting such problems as pointed out earlier.

## Claims

1. A polishing pad (I₁) comprising a large number of resin polishing elements (11), all tubular in shape with a minute diameter, bound together, by inseparably linking an outer peripheral surface of one polishing element in contact to an outer peripheral surface of another, with the axial direction tube end faces aligned on a plane (1a) to form a plate structure (10) with pores (12,13) regularly positioned and arranged and passing therethrough in the axial direction.

2. A polishing pad (l₂) comprising a large number of resin polishing elements (21), all solid bar-like, columnar in shape, with a minute diameter, bound together, by inseparably linking an outer peripheral surface of one polishing element in contact to an outer peripheral surface of another, with the axial direction bar end faces aligned on a plane (1 a), to form a plate structure (20) in such a way that gaps (23) are formed as external through pores in the axial direction by the outer peripheral surfaces, said through pores being regularly positioned and arranged.

3. A polishing pad comprising a plurality of layers placed one upon another with the surface layer formed of the plate structure as defined in claim 1 or claim 2.

4. A polishing pad as claimed in claim 1, wherein each element has an internal diameter of 0.02 to 3 mm.

5. A polishing pad as claimed in claim I or claim 4, wherein the elements are bound together in such a way that gaps are formed as external through pores (13) in the axial direction between the outer peripheral surfaces, said through pores being regularly positioned and arranged.

6. A polishing pad as claimed in claim 2 or claim 5, wherein each external through-pore (13) has a sectional area equivalent to a circle with a diameter of 0.02 to 3 mm.

7. A polishing pad as claimed in any preceding claim which comprises 200 to 1,000,000 elements (11;21).

8. A polishing pad as claimed in any preceding claim, wherein said elements (11;21) are bound together by thermal fusion or with an adhesive.

9. Chemical mechanical polishing apparatus comprising one or more polishing pads as claimed in any preceding claim.

## Patentansprüche

1. Polierkissen (1₁), enthaltend eine große Anzahl von Harzpolierelementen (11), die alle eine rohrartige Form mit einem winzigen Durchmesser haben, zusammengebunden durch unzertrennbares Verbinden einer Außenumfangsfläche eines Polierelements in Kontakt mit einer Außenumfangsfläche eines anderen, wobei die Axialrichtungsrohrendflächen an einer Ebene(1a) ausgerichtet sind, um eine Plattenstruktur (10) mit Poren (12, 13) zu bilden, die regelmäßig positioniert und angeordnet sind und dadurch in der Axialrichtung hindurch gehen.

2. Polierkissen(1₂), enthaltend eine große Anzahl von Harzpolierelementen (21), die alle massivstabartig von säulenartiger Form mit einem winzigen Durchmesser sind, zusammengebunden durch unzertrennbares Verbinden einer Außenumfangsfläche eines Polierelements in Kontakt mit einer Außenumfangsfläche eines anderen, wobei die Axialrichtungsstabendflächen an einer Ebene (1a) ausgerichtet sind, um eine Plattenstruktur (20) in einer solchen Weise zu bilden, dass Lücken (23) als externe Durchgangsporen in der Axialrichtung der Außenumfangsoberflächen ausgebildet sind, welche Durchgangsporen regelmäßig positioniert und angeordnet sind.

3. Polierkissen, enthaltend eine Mehrzahl von Schichten, die aufeinander platziert sind, wobei die Oberflächenschicht aus der Plattenstruktur gebildet ist, wie sie im Anspruch 1 oder im Anspruch 2 definiert ist.

4. Polierkissen nach Anspruch 1, wobei jedes Element einen Innendurchmesser 0,02 bis 3 mm hat.

5. Polierkissen nach Anspruch 1 oder Anspruch 4, wobei die Elemente miteinander in einer solchen Weise verbunden sind, dass Lücken als externe Durchgangsporen (13) in der Axialrichtung zwischen den Außenumfangsoberflächen gebildet sind, welche Durchgangsporen regelmäßig positioniert und angeordnet sind.

6. Polierkissen nach Anspruch 2 oder Anspruch 5, wobei jede Außendurchgangspore (13) eine Querschnittsfläche äquivalent zu einem Kreis mit einem Durchmesser von 0,02 bis 3 mm hat.

7. Polierkissen nach einem der vorhergehenden Ansprüche, welches 200 bis 1.000.000 Elemente (11; 21) hat.

8. Polierkissen nach einem der vorhergehenden Ansprüche, wobei die Elemente (11; 21) miteinander durch thermische Fusion oder mit einem Adhäsiv verbunden sind.

9. Chemisch-mechanisches Poliergerät, enthaltend ein oder mehrere Polierkissen nach einem der vorhergehenden Ansprüche.

## Revendications

1. Un tampon de polissage (I₁) comprenant un grand nombre d'éléments de polissage en résine (11), tous de forme tubulaire avec un très petit diamètre, retenus ensemble en reliant de manière non séparable une surface périphérique externe d'un élément de polissage en contact avec une surface périphérique externe d'un autre élément, avec les faces d'extrémité des tubes de direction axiale alignées sur un plan (1a) afin de former une structure de plaque (10) avec des pores (12,13) placés et disposés de manière régulière et passant à travers dans la direction axiale.

2. Un tampon de polissage (l₂) comprenant un grand nombre d'éléments de polissage en résine (21), tous ressemblant à des barres pleines, en forme de colonne, avec un très petit diamètre, retenus ensemble en reliant de manière non séparable une surface périphérique externe d'un élément de polissage en contact avec une surface périphérique externe d'un autre élément, avec les faces d'extrémité des barres de direction axiale alignées sur un plan (1a) afin de former une structure de plaque (20) de telle manière que des intervalles (23) soient formés en tant que pores traversants externes dans la direction axiale par les surfaces périphériques externes, lesdits pores traversants étant placés et disposés de manière régulière.

3. Un tampon de polissage comprenant une pluralité de couches placées l'une sur l'autre avec la couche de surface formée de la structure de plaque telle que définie à la revendication 1 ou à la revendication 2.

4. Un tampon de polissage tel que revendiqué à la revendication 1, dans lequel chaque élément a un diamètre interne de 0,02 à 3 mm.

5. Un tampon de polissage tel que revendiqué à la revendication 1 ou à la revendication 4, dans lequel les éléments sont retenus ensemble de telle manière que des intervalles soient formés en tant que pores traversants externes (13) dans la direction axiale entre les surfaces périphériques externes, lesdits pores traversants étant placés et disposés de manière régulière.

6. Un tampon de polissage tel. que revendiqué à la revendication 2 ou à la revendication 5, dans lequel chaque pore traversant externe (13) a en section une surface équivalente à un cercle avec un diamètre de 0,02 à 3 mm.

7. Un tampon de polissage tel que revendiqué dans une quelconque revendication précédente qui comprend de 200 éléments à 1 000 000 d'éléments (11;21).

8. Un tampon de polissage tel que revendiqué dans une quelconque revendication précédente, dans lequel lesdits éléments (11;21) sont retenus ensemble par fusion thermique ou à l'aide d'un adhésif.

9. Appareil de polissage mécanique chimique comprenant un ou plusieurs tampons de polissage tel que revendiqué dans une quelconque revendication précédente.
